# EUROPÄISCHE PATENTSCHRIFT

(11) **EP 2 055 154 B1**
(45) Veröffentlichungstag und Bekanntmachung des Hinweises auf die Patenterteilung: **09.03.2011**
(21) Anmeldenummer: 07821616.5
(22) Anmeldetag: 22.10.2007
(51) Int. Cl.: H05K 1/11, H05K 1/16, H05K 3/32, H05K 3/36, H05K 3/40, H05K 5/02, H05K 9/00, H05K 5/06

(54) **STANDARDISIERTES ELEKTRONIKGEHÄUSE MIT MODULAREN KONTAKTPARTNERN**
STANDARDIZED ELECTRONICS HOUSING HAVING MODULAR CONTACT PARTNERS
BOÎTIER ÉLECTRONIQUE NORMALISÉ DOTÉ DE PARTENAIRES MODULAIRES DE CONTACT

(30) Priorität: 13.11.2006 DE 102006053407
(43) Veröffentlichungstag der Anmeldung: 06.05.2009
(73) Patentinhaber: Continental Automotive GmbH, 30165 Hannover (DE)
(72) Erfinder: LOIBL, Josef, 93077 Bad Abbach (DE); SMIRRA, Karl, 83512 Wasserburg (DE)
(86) Internationale Anmeldenummer: PCT/EP2007/061252
(87) Internationale Veröffentlichungsnummer: WO 2008/058828

(56) Entgegenhaltungen:
- WO-A-02/11502
- WO-A-98/44593
- DE-A1-102005 009 443
- US-A1- 2004 080 917

## Beschreibung

Die Erfindung betrifft ein standardisiertes Elektronikgehäuse gemäß dem Oberbegriff des Patentanspruchs 1 sowie ein Verfahren zur Herstellung eines solchen Steuergerätes, insbesondere für Getriebe- oder Motorsteuerungen in der Automobilindustrie.

### Stand der Technik

In der Kraftfahrzeugtechnik werden Komponenten wie Getriebe-, Motoren- oder Bremssysteme zunehmend vornehmlich elektronisch gesteuert. Hierbei gibt es eine Entwicklung hin zu mechatronischen Steuerungen, also zur Integration von Steuerelektronik und den zugehörigen elektronischen Komponenten, wie Sensoren oder Ventile in das Getriebe, den Motor, das Bremssystem oder Ähnlichem. Die Steuergeräte weisen im Allgemeinen eine Vielzahl an elektronischen Komponenten auf, welche in Verbindung mit anderen Komponenten außerhalb des Steuergerätes stehen. Bei solchen integrierten Elektroniken sind diese Steuerungen nicht mehr in einem speziellen, geschützten E-lektronikraum untergebracht. Sie müssen daher entsprechenden Umwelteinflüssen und mechanischen, thermischen sowie chemischen Beanspruchungen standhalten.

Sie werden zu diesem Zweck normalerweise in spezielle Gehäuse eingesetzt. Zudem erfüllen die Gehäuse eine wichtige Abschirmfunktion. Um eine verlässliche Verbindung zu außerhalb des Gehäuses liegenden Komponenten zu ermöglichen, ist eine elektrische Verbindung von der Gehäuseinnenseite zur Gehäuseaußenseite notwendig.

Es sind Systeme bekannt, bei der die Zentralelektronik im Gehäuse an einen Gesamtkomponententräger elektrisch kontaktiert wird. Der Gesamtkomponententräger stellt eine maßgeschneiderte Verbindung von allen außerhalb des Steuergeräts liegenden Komponenten an die Zentralelektronik dar. Diese Anordnung hat folglich jedoch den Nachteil, dass keine flexible Anbindung einzelner peripherer Komponenten an die Zentralelektronik möglich ist. Zudem muss der Gesamtkomponententräger spezifisch für die jeweilige Anwendung und den damit verknüpften bestimmten Anforderungen neu entwickelt und konzipiert werden. Dies ist mit erheblichem Zeit- und Kostenaufwand verbunden.

Ein Konzept zur Flexibilisierung der Verbindung zwischen peripheren Komponenten und Zentralelektronik ist aus der DE 10 2004 036 683 A1 bekannt. Hier wird eine Anordnung zur elektrischen Verbindung von Steuerelektronik zu peripheren Komponenten wie beispielsweise Sensoren, Ventile oder Stecker mittels Ankontaktierung an flexible Leiterplattenteilstücke beschrieben.

Beispielhaft für eine gattungsgemäße Ankontaktierung wird auf die DE 10 2004 050 687 A1 verwiesen. Dort wird eine Möglichkeit zur direkten Kontaktierung eines Kabels oder eines Kabelbündels aufgezeigt, das an eine flexible Leiterplatte angreift.

Auch hier besteht jedoch jeweils der Nachteil, dass für jedes Steuergerät ein individuell angepasstes und auf die beteiligten Komponenten abgestimmtes Layout für das Gehäuse und die Geometrie der flexiblen Leiterplatten gefertigt werden muss. Ändern sich die Vorgaben für die Kontaktierung der peripheren Komponenten oder gar die Größe und die Geometrie des zentralen Elektroniksubstrates, muss zwangsläufig auch ein neues Layout für das Gehäuse und die flexiblen Leiterplatten gefunden und angefertigt werden. Dieser Zwang besteht unabhängig davon, ob die flexiblen Leiterplatten einstückig oder als Teilstücke ausgebildet sind.

### Aufgabenstellung:

Aufgabe der Erfindung ist es daher, ein standardisiertes Elektronikgehäuse bereitzustellen, das eine einfache, sichere und flexible Anbindung funktionaler peripherer Komponenten, wie Sensoren, Satelliten und externer Stecker, ermöglicht. Mithin soll ein Konzept für eine standardisierte, insbesondere für eine modularisierte, Kontaktierung von peripheren Komponenten an ein Elektronikgehäuse zur Verfügung gestellt werden.

Dies wird erfindungsgemäß mit einer Vorrichtung entsprechend des Patentanspruchs 1 sowie mit einem Verfahren zur Herstellung einer solchen Vorrichtung gemäß Anspruch 9 erreicht.

Erfindungsgemäß wird vorgeschlagen, dass die elektronische Verbindung einheitliche, offene Leiterbahnbereiche außerhalb des Gehäusedeckels aufweist, welche mindestens teilweise von Kontaktpartnern abgedeckt werden. Gleichzeitig weisen die Kontaktpartner mindestens eine direkte Kontaktierung zu einer oder mehreren peripheren Komponenten auf. Damit verbindet der erfindungsgemäße Kontaktpartner zwei unterschiedliche Funktionen der Abdeckung und der Kontaktierung, die bisher von separaten Bauteilen übernommen wurden. Darüber hinaus kann mit dieser Zusammenfassung von Funktionalitäten auch eine Standardisierung der Kontaktierung an zentrale Elektroniken von integrierten Mechatroniken erfolgen. Es ist somit erstmals möglich, vorgegebene modulare Kontaktpartner für die einzelnen Komponentenarten bereitzustellen. Auf diese Weise lässt sich nicht nur eine optimale Entflechtung der Signal- und Strompfade erzielen, sondern es ist auch eine flexible Anpassung an unterschiedliche Anordnungen, Funktionalitäten und Geometrien der peripheren Komponenten, wie Sensoren, Ventile oder ähnliches, möglich.

Weitere vorteilhafte Ausgestaltungen und Weiterbildungen, welche einzeln oder in Kombination miteinander eingesetzt werden können, sind Gegenstand der abhängigen Ansprüche.

In einer bevorzugten Ausgestaltung der Erfindung kann ein Kontaktpartner ein oder mehrere integrierte elektrische Anbindungen zu einer oder mehreren peripheren Komponenten aufweisen. Die integrierten Anbindungen können bevorzugt als Kabelenden, Stanzgitter oder Stecker ausgebildet sein.

Damit kann der Kontaktpartner maßgeschneidert auf den jeweiligen Typ der peripheren Komponente, zu der eine Verbindung mit der zentralen Elektronik hergestellt werden soll, ausgelegt werden. Erfindungsgemäß ist somit ein modulares System von verschiedenen Kontaktpartnern ermöglicht, das eine erhebliche Flexibilisierung des Gehäuseaufbaus und zugleich aufgrund der vereinheitlichten Herstellung auch eine erhebliche Kostenreduktion gestattet.

Weiterhin bevorzugt kann der Kontaktpartner gleichzeitig Träger einer oder mehreren peripheren Komponenten sein. Dies hat den Vorteil, dass eine weitere Verkürzung und Entflechtung der Signal- und Strompfade möglich ist. Zusätzlich wird durch diese kompakte Zusammenstellung und Bauweise der zentralen Elektronik einerseits und der damit verbundenen peripheren Komponenten andererseits die Fehler- und Störanfälligkeit deutlich herabgesetzt.

In einer anderen bevorzugten Ausgestaltung der Erfindung überlappen die Kontaktpartner mit dem Rand des Gehäusedeckels. So kann eine dichte Abdeckung, beispielsweise zusätzlich als Labyrinth-Dichtpfad ausgebildet, als Spanschutz und gegen weitere Kontamination durch Umwelteinflüsse erzielt werden. Vorteilhafterweise können die Kontaktpartner die offenen Leiterbahnbereiche vollständig abdecken und mithin eine ansonsten erforderliche Kontaktierungsabdeckung ersetzen. Alternativ können die Kontaktpartner so ausgebildet sein, dass sie bündig mit dem Rand des Gehäusedeckels abschließen und auf diese Weise die Abdeckung und spandichte Abdichtung der offenen Leiterbahnbereiche gewährleisten. Durch die Doppelfunktion der Kontaktpartner kann so eine erhebliche Material- und Kostenersparnis erreicht werden.

Die Verbindungen zwischen den außerhalb des Gehäuses angeordneten elektronischen Komponenten und dem bevorzugt standardisierten Kontaktpartner der vorliegenden Erfindung können auf jede bekannte Weise hergestellt werden. Vorzugsweise ist die Form der Verbindung an die integrierte Anbindung des Kontaktpartners spezifisch für eine periphere Komponente ausgelegt.

Als elektronische Verbindung werden in elektronisch gesteuerten Systemen, insbesondere auch erfindungsgemäß bevorzugt, flexible Leiterplatten eingesetzt. Diese sind besonders geeignet für einen Einsatz bei hohen mechanischen und thermischen Anforderungen, wie sie auch auf dem Gebiet der Motor- und Getriebesteuerungen bei Kraftfahrzeugen vorkommen. Ihre flexible Auslegung ermöglicht eine einfache Anpassbarkeit an unterschiedliche elektrische Bauelemente und/oder Steuerelektroniken. Die elektronische Verbindung kann erfindungsgemäß auch eine mehrlagige flexible Leiterplatte sein, die definitionsgemäß zwei oder mehrere von Isolationsschichten getrennte Leiterbahnebenen aufweisen.

In einer besonders bevorzugten Ausgestaltung des erfindungsgemäßen Gehäuses wird die elektronische Verbindung aus mindestens zwei oder mehreren flexiblen Teilleiterplatten gebildet. Dies ermöglicht zum einen eine weitere Flexibilisierung in der Gestaltung der einzelnen Teilleiterplatten und damit auch eine optimale Nutzenauslastung, zum anderen eine weitere Entflechtung von Signal- und Strompfaden. Zudem erfüllt diese Ausführungsvariante die weiteren vorteilhaften Vorgaben, die Gesamtfläche der flexiblen Leiterplatten an sich gering zu halten, insbesondere aus Kostengründen. Der Einsatz der relativ teuren Flächen der flexiblen Leiterplatten und der Verwurf können auf ein Minimum reduziert werden.

Die flexible Leiterplatte kann beispielsweise aus einer unteren Polyimid-Basisfolie, einer darauf in einer Klebeschicht eingebettet angeordneten metallischen Leiterbahn, vorzugsweise aus Kupfer, und einer Polyimid-Deckfolie bestehen. Es können auch weitere, bevorzugt kostengünstigere, Materialien sowohl für die Basisfolie als auch für die Klebeschicht verwendet werden. So können beispielsweise zur Kostenreduzierung solche Materialien vorgesehen werden, die in einem Spritz-, Lackier- oder Siebdruckverfahren auftragbar sind. Daneben ist es möglich, die Schichtdicke der einzelnen Schichten zu variieren.

Zur Ermöglichung der späteren Aufbringung des Gehäusedeckels kann beispielsweise eine umlaufende Vertiefung zur Aufnahme einer Dichtung oder eines Dichtungsmaterials vorgesehen werden. Alternativ oder kumulativ kann der Gehäusedeckel auch durch Nieten, Kleben oder Löten mit der Grundplatte und/oder der flexiblen Leiterplatte verbunden werden. Wichtig dabei ist vor allem, eine gute Abdichtung zu gewährleisten, sollen die Elektronikbauteile später in aggressiver Umgebung, wie zum Beispiel in einem Getriebe oder in einem Motor, eingesetzt werden.

Wird der Gehäusedeckel mittels Löten befestigt, so wird zunächst eine ununterbrochen umlaufende metallische Bahn auf der Oberfläche flexiblen Leiterplatte angeordnet. Vorzugsweise bildet dieser metallische Bereich die Aufsatzfläche des Gehäusedeckels ab.

Der Gehäuseboden besteht bevorzugter Weise aus einem metallischen Material, besonders bevorzugt ist er aus Aluminium. In einer bevorzugten Ausführungsform der Erfindung wird die flexible Leiterplatte auf den metallischen Gehäuseboden auflaminiert. Dies stellt eine verlässliche, dichte und kostengünstige Fixierung sicher. Der Gehäusedeckel kann aus jedem Material bestehen, das einen ausreichenden Schutz der Elektronik gegenüber den gegebenen Umwelteinflüssen sicherstellt. Neben Gehäusedeckeln aus Kunststoff können auch solche aus metallischen Materialien verwendet werden. Wenn eine Fixierung des Gehäusedeckels mittels Verlöten angestrebt wird, sollte vorzugsweise ein Gehäusedeckel aus Metall vorgesehen werden. Dieser bringt gleichzeitig die notwendigen EMV-Abschirmwerte und eine erhöhte Steifigkeit mit. Alternativ kann auch ein metallisierter Kunststoff-Formkörper eingesetzt werden. In einer vorteilhaften Ausgestaltung wird der Gehäusedeckel jedoch aus einem metallischen Material wie beispielsweise Stahlblech oder Druckguss gefertigt. Dadurch ergeben sich eine erhöhte Langzeitstabilität, eine gute Diffusionsdichte gegenüber aggressiven Chemikalien und verbesserte Abschirmwerte über die gesamte Lebensdauer des Steuergeräts. Der Gehäuseboden kann in einer weiteren Ausgestaltung eine größere Grundfläche aufweisen als der Gehäusedeckel.

Zur Herstellung eines erfindungsgemäßen Gehäuses für ein Steuergerät wird eine einstückige flexible Leiterplatte oder ein oder mehrere flexible Teilleiterplatten auf den Gehäuseboden aufgebracht, die mindestens einen erfindungsgemäßen offenen Bereich der Kupfer-Leiterbahn aufweisen. Die Kontaktierungen zu den elektronischen Komponenten im Inneren des Gehäuses werden hergestellt und anschließend wird der Gehäusedeckel auf den entsprechenden Bereich der elektronischen Verbindung aufgebracht und fixiert. Die offenen Bereiche der flexiblen Leiterplatte mit den anschließend hergestellten Kontaktierungen werden vorzugsweise durch die erfindungsgemäßen Kontaktpartner abgedeckt und vor äußeren Einflüssen geschützt. Solche äußeren Einflüsse können beispielsweise metallische Späne aus Fertigungsrückständen des Getriebe- oder Motorgehäuses beinhalten, die zu Kurzschlüssen der Kontaktierungen oder der offenen Bereiche der Kupfer-Leitungsbahnen führen könnten.

Gemäß der vorliegenden Erfindung werden eine flexible Leiterplatte oder mehrere flexible Teilleiterplatten auf einen Gehäuseboden, bevorzugt aus Aluminium, auflaminiert. Besonders bevorzugt wird die flexible Leiterplatte mittels Acrylkleber auf dem Gehäuseboden fixiert.

Die Erfindung wird nachfolgend in beispielhafter Weise anhand einer Ausführungsvariante in Verbindung mit den Zeichnungen erläutert.

In dieser zeigt:
**Fig. 1** eine perspektivische Draufsicht auf das geschlossene Elektronikgehäuse mit 12 peripheren Komponenten
**Fig. 2** eine teil-explodierte perspektivische Draufsicht des Elektronikgehäuses in Fig. 1,
**Fig. 3** eine Schnittdarstellung eines Teilabschnitts des Elektronikgehäuses und des Kontaktierbereiches.

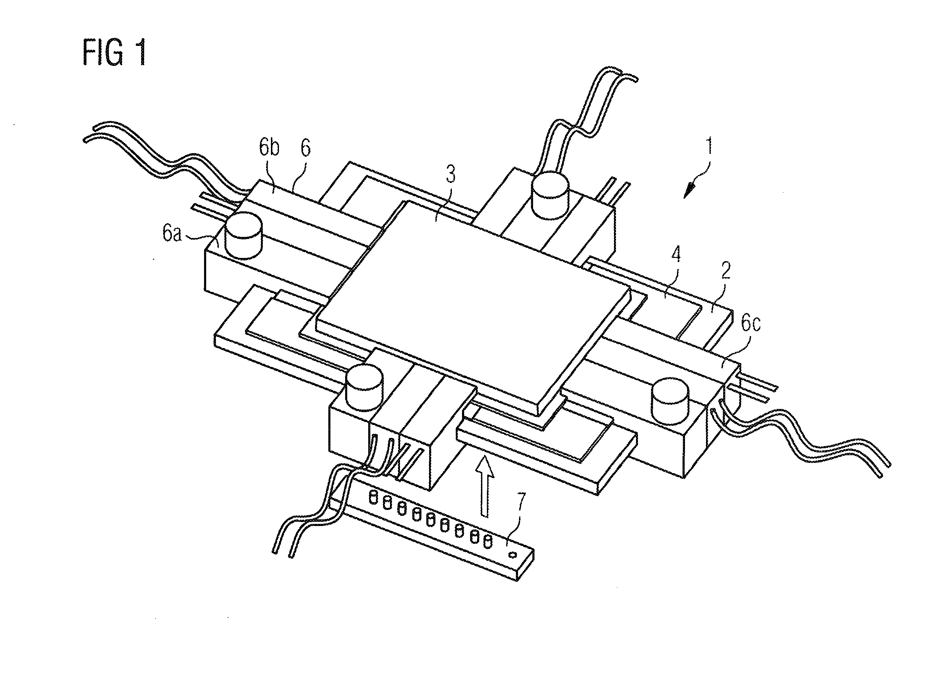

**Fig. 1** zeigt ein erfindungsgemäßes Elektronikgehäuse **1,** das zum Einbau in ein Kraftfahrzeuggetriebe vorgesehen ist. Das Gehäuse **1** wird von einer metallischen Bodenplatte **2** und einem Gehäusedeckel **3** aus Stahlblech gebildet. Auf der metallischen Bodenplatte **2** ist eine flexible Leiterplatte **4** fixiert. Der Gehäusedeckel **3** kann aus Kunststoff, Metall oder Verbundwerkstoffen bestehen und ist vorzugsweise hermetisch dicht mit der Leiterplatte verbunden. Innerhalb des Gehäuses befindet sich ein Elektronik-Substrat **5** (nicht gezeigt). An jeder Seite des Gehäuses **1** sind in dieser Ausgestaltung jeweils drei Kontaktpartner **6** für eine periphere Komponente mit unterschiedlichen Funktionalitäten angeordnet. Als integrierte Anbindungen für eine periphere Komponente sind beispielhaft ein Sensorelement **6a,** das besonders bevorzugt direkt auf dem Kontaktpartner **6** angeordnet ist, eine Kabelverbindung **6b** und ein Stanzgitter (Stecker) **6c** dargestellt. Die erfindungsgemäßen Kontaktpartner **6** sind jeweils so mit dem Gehäuse **1** verbunden, dass eine Anbindung und elektrische Kontaktierung zu den offenen Cu-Zonen **8** der flexiblen Leiterplatte **4** hergestellt wird. Vorteilhafterweise ist die Ausgestaltung und Anbindung der Kontaktpartner **6** dergestalt angepasst, dass die offenen Leiterbahnbereiche **8** der flexiblen Leiterplatte **4** vollständig und mindestens spandicht abgedeckt werden. So kann auf eine zusätzliche Kontaktierabdeckung oberhalb der Leiterplatte **4** verzichtet werden. Gegebenenfalls können, wie separat abgebildet, zusätzliche Kontaktierabdeckungen **7** als Spanschutz und Schutz vor anderen Umwelteinflüssen vorgesehen werden.

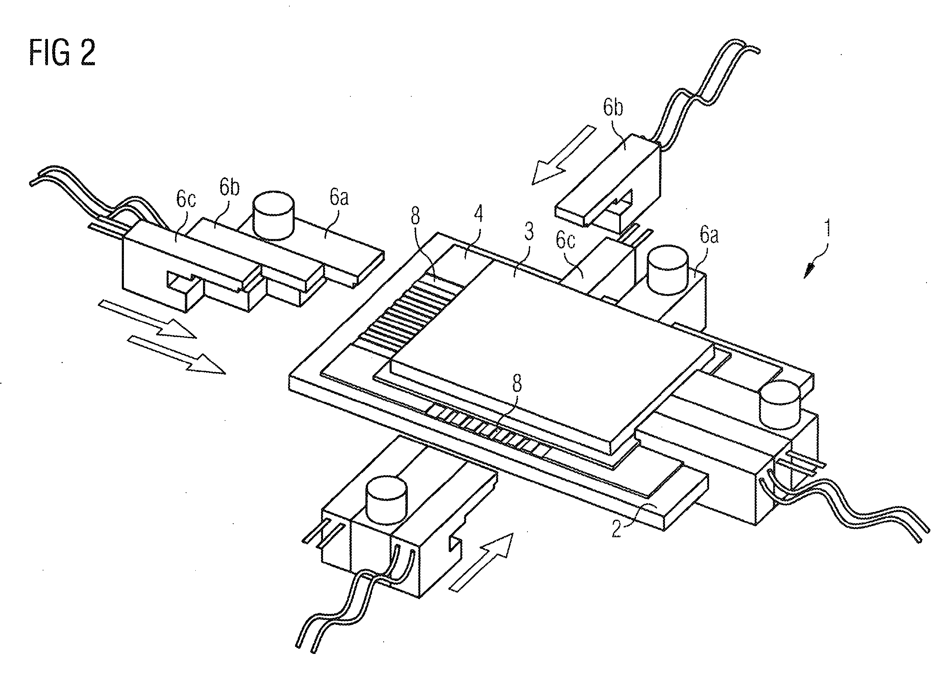

**Fig. 2** zeigt das Elektronikgehäuse aus Fig. 1 in teilexplodierter Darstellung. Die Bodenplatte **2** trägt die flexible Leiterplatte **4,** wobei der Gehäusedeckel **3** umlaufend fest, vorzugsweise hermetisch dicht, direkt auf der flexiblen Leiterplatte **4** angeordnet ist. Die flexible Leiterplatte **4** hat eine größere Fläche als der Gehäusedeckel **3** und ragt unter der Aufsatzfläche des Deckels **3** hervor. In der Darstellung hat die Bodenplatte **2** wiederum eine größere Fläche als die flexible Leiterplatte **4.** In alternativen Ausgestaltungen der Erfindung ist es jedoch ohne weiteres möglich, dass die flexible Leiterplatte **4** ganz oder teilweise über die Bodenplatte **2** herausragt. Die offenen Cu-Zonen **8** der flexiblen Leiterplatte **4** als Kontaktierungsstellen sind außerhalb des Gehäusedeckels **3** im Randbereich der Leiterplatte **4** angeordnet. An einer Seite der Leiterplatte **4** sind in der Darstellung die offenen Kontaktierungsstellen **8** mit den erfindungsgemäßen Kontaktpartnern **6** verbunden und durch diese abgedeckt. An den anderen Seiten ist mit den Pfeilen die Anordnung für die Anbindung der noch losen Kontaktpartner **6** an das Gehäuse **1** dargestellt. Beispielsweise können die Kontaktpartner **6** auf die zentrale Gehäuseeinheit **1** formschlüssig aufgesteckt werden. Es kann hierbei zusätzlich eine mechanische Halterung und/oder Sicherung, beispielsweise ein Clipmechanismus, vorgesehen sein. Die Kontaktpartner **6** können in sich schon untereinander verbunden und damit einstückig als ein Bauteil ausgestaltet sein oder als Einzel-Module mit dem Gehäuse **1** verbunden werden. Die Kontaktpartner **6** können in verschiedener beliebiger Abfolge angebunden werden. So kann eine optimale Entflechtung der Signal- und Strompfade gewährleistet werden.

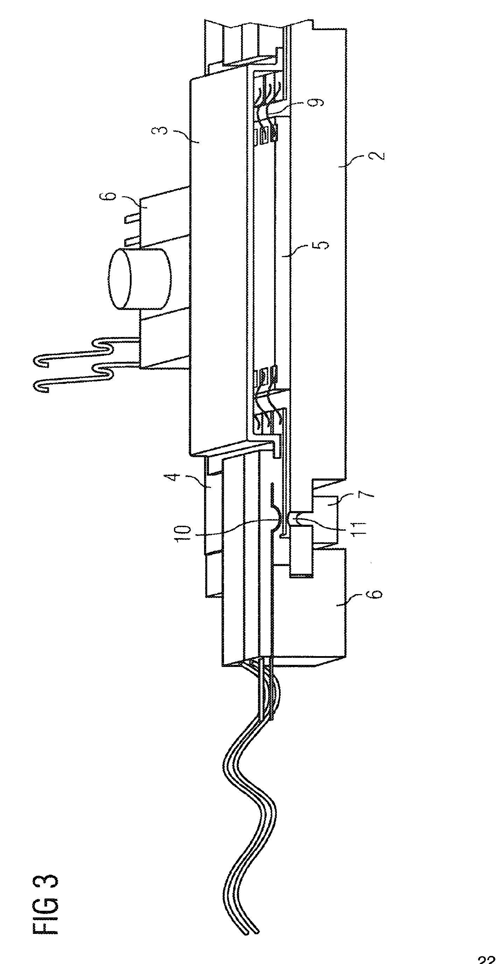

**Fig. 3** zeigt in einer Schnittdarstellung den Aufbau des Gehäuses **1** aus Fig. 1 und 2 mit angebundenen Kontaktpartnern **6.** Das Gehäuse **1** wird von einer metallischen Bodenplatte **2** aus Aluminium und einem Gehäusedeckel **3** aus Stahlblech gebildet. Auf der metallischen Bodenplatte **2** ist eine flexible Leiterplatte **4** fixiert. Der Gehäusedeckel **3** ist umlaufend fest, vorzugsweise hermetisch dicht, direkt auf der flexiblen Leiterplatte **4** angeordnet. Innerhalb des Gehäuses befindet sich ein Elektronik-Substrat **5.** Weiterhin ist die gezeigte flexible Leiterplatte **4** im Innenbereich des Gehäuses ausgeschnitten und in dem so entstandenen Ausschnitt ist das elektronische Substrat **5** angeordnet. Die Verbindungen von dem elektronischen Substrat **5** zur flexiblen Leiterplatte **4** werden mittels Dickdraht-Bonden **9** hergestellt. Die elektrische Kontaktierung **10** zu den erfindungsgemäßen Kontaktpartnern **6** kann beispielsweise mittels Laserschweißen, Löten, Crimpen oder Bonden hergestellt werden. Die Kontaktierabdeckung **7** ist mit Befestigungsmitteln an der Bodenplatte **2** des Elektronikgehäuses **1** festgelegt. Gemäß der vorliegenden bevorzugten Ausgestaltung der Erfindung weist der Gehäuseboden **2** im Bereich der Kontaktierungsstelle **10** zu den Kontaktpartnern **6** eine Aussparung **11** auf, die hier durch eine in die Aussparung **11** hineinragende Abdeckung **7** verschlossen ist.

## Patentansprüche

1. Elektronikgehäuse (1) mit mindestens zwei Gehäuseteilen, welches mindestens einen Gehäuseboden (2), einen Gehäusedeckel (3) und mindestens eine elektronische Verbindung (4) in Form einer Leiterplatte zwischen im Gehäuseinnenraum angeordneten Bauteilen (5) und außerhalb des Gehäuses liegenden Komponenten aufweist, die auf dem Gehäuseboden (2) fixiert ist, **dadurch gekennzeichnet, dass** die elektronische Verbindung (4) offene Leiterbahnbereiche (8) außerhalb des Gehäusedeckels (3) aufweist, wobei die offenen Leiterbahnenbereiche (8) mindestens teilweise von einem oder mehreren Kontaktpartnern (6) abgedeckt werden, und wobei die Kontaktpartner (6) gleichzeitig mindestens eine direkte Kontaktierung zu einem oder mehreren offenen Leiterbahnbereichen (8) aufweisen.

2. Elektronikgehäuse (1) nach Anspruch 1, **dadurch gekennzeichnet, dass** ein Kontaktpartner (6) ein oder mehrere integrierte elektrische Anbindungen zu einer oder mehreren peripheren Komponenten aufweist .

3. Elektronikgehäuse (1) nach Anspruch 1 oder 2, **dadurch gekennzeichnet, dass** ein Kontaktpartner (6) gleichzeitig Träger einer oder mehreren peripheren Komponenten ist.

4. Elektronikgehäuse (1) nach einem der vorhergehenden Ansprüche, **dadurch gekennzeichnet, dass** die elektronische Verbindung (4) eine flexible Leiterplatte, insbesondere eine mehrlagige flexible Leiterplatte, ist.

5. Elektronikgehäuse (1) nach einem der vorhergehenden Ansprüche, **dadurch gekennzeichnet, dass** die elektronische verbindung (4) aus mindestens zwei oder mehreren flexiblen Teilleiterplatten gebildet wird.

6. Elektronikgehäuse (1) nach einem der vorhergehenden Ansprüche, **dadurch gekennzeichnet, dass** der Gehäuseboden (2) eine größere Grundfläche aufweist als der Gehäusedeckel (3).

7. Elektronikgehäuse (1) nach einem der vorhergehenden Ansprüche, **dadurch gekennzeichnet, dass** die Kontaktpartner (6) mit dem Rand des Gehäusedeckels (3) überlappen.

8. Elektronikgehäuse (1) nach einem der vorhergehenden Ansprüche 1 bis 6, **dadurch gekennzeichnet, dass** die Kontaktpartner (6) bündig mit dem Rand des Gehäusedeckels (3) abschließen.

9. Verfahren zur Herstellung eines Gehäuses (1) mit den Merkmalen mindestens eines der vorhergehenden Ansprüche, **dadurch** gekenntzeichnet, dass mindestens eine elektronische Verbindung (4) auf den Gehäuseboden (2) aufgebracht wird, mit dem elektronischen Substrat im Innern des Gehäuses (5) verbunden wird, der Gehäusedeckel (3) befestigt wird und die Komponenten, die außerhalb des Gehäuses liegen, mindestens teilweise durch die Kontaktpartner (6) angebunden werden.

10. Verfahren nach Anspruch 9, **dadurch gekennzeichnet, dass** die Verbindung des elektronischen Substrats (5) mit der elektronischen Verbindung (4) mittels Dickdraht-Bonden und die Verbindung der Kontaktpartner (6) mit der elektronischen Verbindung (4) mittels Lötens, Schweißen oder Crimpen durchgeführt wird.

## Claims

1. Electronics housing (1) with at least two housing parts, which has at least one housing base (2), a housing cover (3) and at least one electronic connection (4) in the form of a printed circuit board between modules (5) disposed in the housing interior and components outside the housing, which is fixed to the housing base (2),
**characterised in that** the electronic connection (4) has open conductor track regions (8) outside the housing cover (3), the open conductor track regions (8) being covered at least partially by one or more contact partners (6) and the contact partners (6) having at least one direct contact with one or more open conductor track regions (8) at the same time.

2. Electronics housing (1) according to claim 1, **characterised in that** a contact partner (6) has one or more integrated electrical interfaces with one or more peripheral components.

3. Electronics housing (1) according to claim 1 or 2, **characterised in that** a contact partner (6) is the support for one or more peripheral components at the same time.

4. Electronics housing (1) according to one of the preceding claims, **characterised in that** the electronic connection (4) is a flexible printed circuit board (4), in particular a multilayer flexible printed circuit board (4).

5. Electronics housing (1) according to one of the preceding claims, **characterised in that** the electronic connection (4) is formed from at least two or more flexible partial printed circuit boards.

6. Electronics housing (1) according to one of the preceding claims, **characterised in that** the housing base (2) has a larger base area than the housing cover (3).

7. Electronics housing (1) according to one of the preceding claims, **characterised in that** the contact partners (6) overlap with the edge of the housing cover (3).

8. Electronics housing (1) according to one of the preceding claims 1 to 6, **characterised in that** the contact partners (6) terminate flush with the edge of the housing cover (3).

9. Method for producing a housing (1) with the features of at least one of the preceding claims, **characterised in that** at least one electronic connection (4) is positioned on the housing base (2), is connected to the electronic substrate inside the housing (5), the housing cover (3) is secured and the components outside the housing are interfaced at least partially by the contact partners (6).

10. Method according to claim 9, **characterised in that** the electronic substrate (5) is connected to the electronic connection (4) by means of thick wire bonding and the contact partners (6) are connected to the electronic connection (4) by means of soldering, welding or crimping.

## Revendications

1. Boîtier électronique (1) comprenant au moins deux parties de boîtier, qui présente au moins un fond de boîtier (2), un couvercle de boîtier (3) et au moins une connexion électronique (4) sous la forme d'un circuit imprimé entre des composants (5) aménagés dans l'espace interne du boîtier et des composants situés à l'extérieur du boîtier, qui est fixé sur le fond de boîtier (2), **caractérisé en ce que** la connexion électronique (4) présente des zones découvertes (8) de pistes conductrices à l'extérieur du couvercle de boîtier (3), dans lequel les zones découvertes (8) de pistes conductrices sont recouvertes au moins en partie par un partenaire de contact (6) ou plus et dans lequel les partenaires de contact (6) présentent une mise en contact directe avec une zone découverte (8) de pistes conductrices ou plus.

2. Boîtier électronique (1) selon la revendication 1, **caractérisé en ce qu'**un partenaire de contact (6) présente une connexion électrique intégrée ou plus avec un composant périphérique ou plus.

3. Boîtier électronique (1) selon la revendication 1 ou 2, **caractérisé en ce qu'**un partenaire de contact (6) est simultanément un support d'un composant périphérique ou plus.

4. Boîtier électronique (1) selon l'une quelconque des revendications précédentes, **caractérisé en ce que** la connexion électronique (4) est un circuit imprimé flexible, en particulier un circuit imprimé flexible à multicouche.

5. Boîtier électronique (1) selon l'une quelconque des revendications précédentes, **caractérisé en ce que** la connexion électronique (4) est formée d'au moins deux circuits imprimés partiels flexibles ou plus.

6. Boîtier électronique (1) selon l'une quelconque des revendications précédentes, **caractérisé en ce que** le fond de boîtier (2) présente une surface de base plus grande que celle du couvercle de boîtier (3).

7. Boîtier électronique (1) selon l'une quelconque des revendications précédentes, **caractérisé en ce que** les partenaires de contact (6) chevauchent le bord du couvercle de boîtier (3).

8. Boîtier électronique (1) selon l'une quelconque des revendications 1 à 6, **caractérisé en ce que** les partenaires de contact (6) se terminent à fleur avec le bord du couvercle de boîtier (3).

9. Procédé de fabrication d'un boîtier (1) ayant les caractéristiques d'au moins l'une des revendications précédentes, **caractérisé en ce qu'**au moins une connexion électronique (4) est appliquée sur le fond de boîtier (2) et est connectée au substrat électronique à l'intérieur du boîtier (5), le couvercle de boîtier (3) est fixé et les composants, qui se trouvent à l'extérieur du boîtier, sont connectés au moins en partie par les partenaires de contact (6).

10. Procédé selon la revendication 9, **caractérisé en ce que** la connexion du substrat électronique (5) avec la connexion électronique (4) se fait par connexion à gros fil et la connexion des partenaires de contact (6) avec la connexion électronique (4) par brasage, soudage ou sertissage.
